Europäisches Patentamt

European Patent Office

Office européen des brevets

(19)

(11) Veröffentlichungsnummer: **0 087 590**
**B1**

(12) **EUROPÄISCHE PATENTSCHRIFT**

(45) Veröffentlichungstag der Patentschrift:
21.03.90

(21) Anmeldenummer: 83100792.7

(22) Anmeldetag: 28.01.83

(51) Int. Cl.⁵: **H 01 M 6/18**, G 02 F 1/17,
**H 03 K 3/00**

(54) Elektrochemische Zelle mit festen Elektroden und einem zwischenliegenden ionenleitenden keramischen Festelektrolyten.

(30) Priorität: 27.02.82 DE 3207131

(43) Veröffentlichungstag der Anmeldung:
07.09.83 Patentblatt 83/36

(45) Bekanntmachung des Hinweises auf die Patenterteilung:
21.03.90 Patentblatt 90/12

(84) Bennante Vertragsstaaten:
AT BE CH DE FR GB IT LI LU SE

(56) Entgegenhaltungen:
DE-A-3 032 894
DE-A-3 123 099
FR-A-2 282 171
FR-A-2 489 592
GB-A-2 081 922
US-A-4 105 807
US-A-4 106 862

SOLID STATE IONICS, Band 1, Nr. 3, August 1980, Seiten 163-175, North-Holland Publishing Co., Amsterdam, NL; T. TAKAHASHI et al.: "Solid-state ionics-conductivities of Na+ ion conductors based on nasicon"

(73) Patentinhaber: VARTA Batterie Aktiengesellschaft
Am Leineufer 51
D-3000 Hannover 21 (DE)
Patentinhaber: Hoechst CeramTec Aktiengesellschaft
Wilhelmstrasse 14
D-8672 Selb (DE)

(72) Erfinder: von Alpen, Ullrich, Dr.
Im Kastanienhain 5
D-6246 Schlossborn (DE)
Erfinder: Schindler, Stefan, Dr.
Häussellohweg 42
D-8672 Selb/Bayern (DE)
Erfinder: Schelter, Heinrich
Unterweissenbach 75
D-8672 Selb/Bayern (DE)

(74) Vertreter: Kaiser, Dieter Ralf, Dipl.-Ing.
Gundelhardtstrasse 72
D-6233 Kelkheim/Ts. (DE)

## Beschreibung

Die Erfindung betrifft eine elektrochemische Zelle mit festen Elektroden und einem zwischenliegenden ionenleitenden keramischen Festelektrolyten auf Basis einer Mischkristallverbindung vom Natriumzirkonphosphatosilikat-Typ, die eine Mindestleitfähigkeit $\sigma = 10^{-3} \, \Omega^{-1} \, cm^{-1}$ bei Raumtemperatur besitzt.

Das Anwendungsgebiet der Erfindung erstreckt sich insbesondere auf elektronische Bauelemente.

Die Entwicklung elektronischer Bauelemente tendiert dahin, daß durch Großintegration immer mehr elektronische Funktionen auf immer weniger Raum konzentriert werden. Diese Entwicklung umfaßt sowohl passive Bauelemente wie z. B. Speicherelemente als auch aktive Elemente wie z. B. Optokoppler. Die Verbindung der einzelnen elektronischen Bauelemente zu Schaltungen geschieht nach dem Stand der Technik auf sog. Leiterplatinen, das sind Kunststoffplatten mit aufgedruckten, eingeätzten oder photochemisch erzeugten Leitungsbahnen der Schaltkreise. Der Integrationsgrad auf diesen Platinen ist ebenfalls als Folge der Entwicklung zunehmend gestiegen, stößt aber materialbedingt durch die Zusammensetzung des Trägermaterials an eine Grenze, die durch die Leitfähigkeit, die thermische Belastbarkeit und die chemische Stabilität des Materials gegeben ist.

Ein Problem bei der Großintegration ist insbesondere die durch die Anhäufung elektrischer Bauteile entstehende unkontrollierte Wärmebelastung, da die thermische Leitfähigkeit von Kunststoffen zu gering ist, um eine kontrollierte thermische Ableitung zu gewährleisten. Außerdem ist der Erweichungspunkt der Kunststoffplatinen so niedrig, daß die elektrische Schaltarchitektur gestört wird.

Aus der DE-OS-2 727 364 ist ein Verfahren zur Herstellung eines bandförmigen Keramiksubstrats auf der Basis von Tonerde durch Strangpressen und Glühen der geschnittenen Formstükke bekannt, die sich als keramische Platinen von hoher thermischer Belastbarkeit anbieten. Die ungebrannten Grünlinge sind einer Plastifizierung zugänglich, so daß Platinen beliebiger Struktur und Größe gewalzt und gebrannt werden können. Die Oberflächengüte der erhaltenen Substrate erlaubt die Aufbringung von Leiterbahnen sowohl für Dickschicht- als auch für Dünnschichtschaltungen. Gemäß der europäischen Patentanmeldung 0036 435 A 1 ist es sogar mit geeigneten Techniken möglich, keramische Mehrschichtgehäuse zur Aufnahme elektronischer Schaltungen herzustellen, die einen noch höheren Integrationsgrad erlauben.

Parallel mit den Fortschritten der Mikroelektronik vollzog sich, jeweils gesondert für sich, die Miniaturisierung der zum Betreiben der Elektronik notwendigen Batterien in Form der Knopfzellen und die Fortentwicklung der in elektronischen Geräten vorhandenen Anzeigen, die entweder auf stromintensive, aber kontraststarke LED-Systeme oder auf sehr kontrastarme, dafür hochohmige LCD-Systeme zurückgehen.

Auf elektrochemischen Vorgängen beruhen hingegen elektrochrome Anzeigesysteme, wie sie beispielsweise in der US-A-4 106 862 oder in der GB-A-2 081 922 beschrieben werden. Bei diesen handelt es sich um Kombinationen einer sogenannten Display-Elektrode aus z. B. $WO_3$ mit einer Gegenelektrode aus Natriumwolframat sowie einem zwischenliegenden Na-ionenleitenden Festkörperelektrolyten. Durch ein elektrisches Feld, erzeugt durch Anlegen einer Spannung an die Elektroden, werden im Festelektrolyt vorhandene Na-Ionen zur Display-Elektrode hingezogen, wo sie mit dem $WO_3$ zu einer blau gefärbten Wolfram-"Bronze" reagieren.

Mit der präparativen Darstellung und den Eigenschaften Na-ionenleitender Festkörperelektrolyte vom NASICON-Typ ist ein Aufsatz in "Solid State Ionics", Bd. 1 (1980), Seiten 163 - 175, befaßt. In den älteren, nicht vorveröffentlichten DE-A-3 123 099 und DE-A-3 032 894 wird offenbart, daß derartige Natriumzirkonphosphatosilikat-Mischkristallverbindungen Leitfähigkeiten in der Größenordnung $\delta = 10^{-3} \, \Omega^{-1} \, cm^{-1}$ bei Raumtemperatur besitzen können und daß sie sich außer in Batterien auch in elektrochromen Anzeigevorrichtungen als Festelektrolyte eignen.

Der Erfindung liegt die Aufgabe zugrunde, eine elektrochemische Zelle mit einem solchen Mischkristallmaterial als Festelektrolyt verfügbar zu machen, die eine Integration von elektronischen und optischen Bauelementen gestattet und die auch funktionsmäßig mit diesen Elementen verkoppelt ist.

Die Aufgabe wird erfindungsgemäß durch eine elektrochemische Zelle gelöst, wie sie in Patentanspruch 1 angegeben ist.

Ein besonders vorteilhaftes Festkörperelektrolytmaterial besteht aus Mischkristallen der allgemeinen Zusammensetzung

$Na_{1+x}Zr_{2-1/3x+y}Si_xP_{3-x}O_{12-2/3x+2y}$ mit den Laufparametern $1,0 < x < 2,4$ und $0,1 < y < 0,2$ oder $Na_{1+ax}Zr_{2+2/3x-ax}Si_xP_{3-x}O_{12-2/3x}$ mit a = konstant. Zahlenwert zwischen 0,8 und 0,9 und dem Laufparameter $1,8 < x < 2,3$.

Die Gründe für die besondere Eignung erfindungsgemäßer Festkörperelektrolyte als Trägermaterial sind mehrfacher Art: wegen der sehr geringen Elektronenleitfähigkeit sind sie praktisch elektrische Isolatoren und damit als Substrathalter für die elektronischen Komponenten wie Mikroprozessoren und/oder Quarztreiber verwendbar. Sie sind für diese Aufgabe dem bisher eingesetzten α-Korund sogar vorzuziehen, da das erfindungsgemäße Material bei einer niedrigeren Sintertemperatur von etwa 1250°C, im Vergleich zu 1650 bis 1750°C bei α-Korund, erhältlich ist und andererseits eine höhere Temperaturwechselbeständigkeit besitzt. Den Beweis dafür lieferte ein Vergleich zwischen einem Material aus der vorgenannten deutschen Patentanmeldung P 3 032 894 mit der vorzugsweisen Zusammensetzung $Na_{2,94}Zr_{1,40}Si_{2,2}P_{0,8}O_{10,53}$ und $\alpha$-Korund nach DIN 51068. Bei vergleichbaren äußeren Abmessungen der Probekörper war die erfindungsgemäße Zusammensetzung erst nach 6 Aufheiz- und Abkühlzyklen in verschiedene Teile gesprungen, während $\alpha$-Korund aufgrund seiner geringen Temperaturwechselbeständigkeit schon nach dem ersten Zyklus gesprungen ist.

Die zweite Funktion des erfindungsgemäßen Keramiksubstrats besteht darin, daß es wegen seiner Ionenleitfähigkeit unmittelbar die Rolle des Elektrolyten für Festkörperbatterien auf Na-Basis übernehmen kann, während es andererseits aufgrund seiner ober erwähnten elektronischen Isolationseigenschaften die Bedingung eines Trägers für Schichtschaltungen erfüllt. Damit aber bietet sich die Integration von elektronischen und elektrochemischen Bauelemente auf einem gemeinsamen Trägersubstrat an. Zugleich wird unter Einbeziehung geeigneter Beschichtungstechnologien wie Aufdampfen, Siebdrucken usw. eine kontinuierliche, kostengünstige Fertigung von Einzelsubstraten aus der plastifizierten Folie möglich.

Eine Batterie, z. B. für die Speichererhaltung oder als elektrische Stromversorgung, kann derart integriert werden, daß an der für die Stromquelle vorgesehenen Stelle das plastifizierte Keramiksubstrat entweder geeignet vorgeformt wird, z. B. durch Aufbringen erhabener Strukturen, oder daß durch Zugabe von Ausbrennstoffen wie z. B. Stärkeverbindungen eine besonders poröse Ausbildung des Keramiksubstrates erfolgt. Die aktiven Materialien wie z. B. Natrium für die Anodenseite und Verbindungen wie z. B. $AlCl_3$, $BiCl_3$ oder $WCl_6$ für die Kathodenseite können im schmelzflüssigen Zustand auf diese strukturierten Stellen aufgebracht werden. Bei Materialien mit Schmelzpunkten oberhalb 200°C oder mit hohen Dampfdrücken empfiehlt es sich, diese Materialien auf den Substrathalter aufzupressen. Da Na-basierende elektrochemische Elemente wegen der hohen Reaktivität von Natrium bzw. seiner Verbindungen mit Wasser bzw. Sauerstoff unter Schutzgas abgeschlossen betrieben werden müssen, müssen Anoden- bzw. Kathodenbauteile auf dem Substrathalter geeignet eingekapselt werden. Das erfindungsgemäße Keramiksubstrat eröffnet hier in vorteilhafter Weise die Möglichkeit, durch eine Mehrschichtstruktur nicht nur die elektronischen Leiterbahnen über mehrere Ebenen zu verteilen, sondern auch Hohlräume vorzusehen, die nach dem Brennen des Substrats mit dem aktiven Material schmelzflüssig gefüllt werden können. Nachdem die aktiven Massen erstarrt sind, können die Zuführungslöcher z. B. mit einem Glaslot verschlossen werden, die Stromquellen sind mithin in der Vielschichtstruktur integriert. Die metallischen Ableiter werden bereits vor dem Brennprozeß auf die Struktur aufgebracht.

In einer besonders vorteilhaften Ausführungsform der Erfindung dient das Keramiksubstrat auch noch als Festelektrolyt für eine elektrochrome Anzeige (ECD), vervollständigt somit die Integrierbarkeit elektronischer Bauelemente mit optischen und elektrochemischen Bauteilen auf einem keramischen Mehrschichtgehäuse. Hierbei erweist sich die weiße Farbe des erfindungsgemäßen Festkörperelektrolyten als sehr günstig, wenn man ein Festkörper-ECD mit z. B. $WO_3$ verwendet, welches durch Blaufärbung infolge elektrochemischer Vorgänge (Diffusion von $Na^+$-Ionen) vor einem weißen Hintergrund kontrastreich absticht. Die Stromversorgung für das ECD kann getrennt z. B. im gleichen Mehrschichtgehäuse unter dem ECD angebracht werden; dies würde eine geringe Bauhöhe bei einer Fläche bedeuten, die nur durch den Anzeigeschirm bestimmt ist. Diese Anzeige hat neben der Augenfälligkeit auch die günstige Eigenschaft der Speicherbarkeit der Information.

Figur 1 zeigt ein Beispiel einer vorzugsweisen Ausführungsform der Erfindung.

Das nach modernen Methoden der Keramiktechnologie herstellbare Mehrschichtgehäuse 1 aus einem erfindungsgemäßen Natriumzirkonphosphatosilikat-Festkörperelektrolyten enthält in den durch die Schichten gebildeten Zwischenräumen, der Reihe nach von unten, eine positive Batterieelektrode 2 und eine negative Na-Elektrode 3, des weiteren eine Natriumwolframat-Elektrode 4 und auf der obersten Schicht als deren Gegenelektrode eine in Segmenten aufgedampfte und die weiße Schichtoberfläche nur zum Teil bedeckende $WO_3$-Belegung 5. Letztere Elektroden bilden zusammen mit einer $SiO_2$-Isolatorschicht 6 und einem transparenten Ableiter 7 aus Sn-dotiertem $In_2O_3$ sowie dem Deckglas 8 ein vollständiges elektrochromes Display. Leiterbahnen aus Au, Pt oder anderen Edelmetallen verbinden alle diese elektrochemischen Bauelemente mit einer im Fuß des Gehäuses angeordneten Ansteuerelektronik 10, die hier z. B. aus einem Mikroprozessor 11 und einer Quarztreiberstufe 12, beide verkapselt, besteht.

Es ist sogar möglich, die beiden positiven Elektrodenfunktionen 2 und 4 auf nur eine positive Elektrode, z. B. die Natriumwolframat-Elektrode 4, zu vereinigen, so daß die Energieversorgung der elektronischen Bauelemente und des ECD aus einer gemeinsamen elektrochemischen Stromquelle heraus erfolgt. Auf diese Weise kann eine der Taschen zur Aufnahme von aktivem positiven Elektrodenmaterial eingespart werden.

Die Erfindung gestattet es somit erstmals, elektronische, optische und elektrochemische Funktionen auf ein und demselben keramischen Substrathalter zu vereinigen. Eine programmierbare Prozessorlogik vorausgesetzt, ermöglicht dieses Konzept eine Vielzahl von Gerätefunktionen wie Zeituhr, Multimeterfunktion usw. mit einem Aufbau zu erfüllen. Die Möglichkeit, plastifizierte Keramikbänder technisch zu handhaben, zeigt den Weg zu einer kostengünstigen Fertigung.

## Patentansprüche

1. Elektrochemische Zelle mit festen Elektroden und einem zwischenliegenden ionenleitenden keramischen Festelektrolyten auf Basis einer Mischkristallverbindung vom Natriumzirkonphosphatosilikat-Typ, die eine Mindestleitfähigkeit $\delta = 10^{-3}$ $\Omega^{-1}$ $cm^{-1}$ bei Raumtemperatur besitzt, dadurch gekennzeichnet, daß ihre Elektroden in den Zwischenräumen eines mehrschichtigen Gehäuses (1) aus dem ionenleitenden keramischen Festelektrolytmaterial angeordnet sind und daß auf den Schichten des Gehäuses elektronische Bauelemente oder integrierte elektronische Schaltkreise (11, 12) angeordnet sind, die mit den Elektroden der elektrochemischen Zelle gekoppelt sind.

2. Elektrochemische Zelle nach Anspruch 1, dadurch gekennzeichnet, daß eine der Schichten des mehrschichtigen Gehäuses der Festelektrolyt einer elektrochromen Anzeige ist.

3. Elektrochemische Zelle nach Anspruch 2, dadurch gekennzeichnet, daß im ersten Zwischenraum des mehrschichtigen Gehäuses eine positive Batterieelektrode (2), im zweiten Zwischenraum eine Na-Elektrode (3) und im dritten Zwischenraum eine Natriumwolframat-Elektrode (4) angeordnet ist, und daß die äußeren Gehäuseschichten als Trägersubstrat für eine elektrochrome WO3-Schicht und für elektronische Schaltelemente dienen.

4. Elektrochemische Zelle nach einem der Ansprüche 1 bis 3, dadurch gekennzeichnet, daß das Material für das Gehäuse aus Mischkristallen der allgemeinen Zusammensetzung

$$Na_{1+x}Zr_{2-1/3x+y}Si_xP_{3-x}O_{12-2/3x+2y}$$

mit den Laufparametern $1,0 < x < 2,4$ und $0,1 < y < 0,2$ oder

$$Na_{1+ax}Zr_{2+2/3x-ax}Si_xP_{3-x}O_{12-2/3x}$$

mit a = konst. Zahlenwert zwischen 0,8 und 0,9 und dem Laufparameter $1,8 < x < 2,3$ besteht.

## Claims

1. Electrochemical cell having solid electrodes and an intermediate ion-conductive ceramic solid electrolyte on the basis of a mixed crystal compound of the sodium zirconium phosphatosilicate type which has a minimum conductivity $\sigma = 10^{-3}\Omega^{-1}$ $cm^{-1}$ at room temperature, characterized in that its electrodes are arranged in the interspaces of a multilayer box (1) made of the ion-conductive ceramic solid electrolyte material, and in that electronic components or integrated electronic circuits (11, 12) which are coupled to the electrodes of the electrochemical cell are arranged on the layers of the box.

2. Electrochemical cell according to Claim 1, characterized in that one of the layers of the multilayer box is the solid electrolyte of an electrochromic display.

3. Electrochemical cell according to Claim 2, characterized in that there is arranged in the first interspace of the multilayer box a positive battery electrode (2), a negative Na electrode (3) in the second interspace and a sodium tungstate electrode (4) in the third interspace, and in that the outer box layers serve as a carrier substrate for an electrochromic WO3 layer and for electronic switching elements.

4. Electrochemical cell according to one of Claims 1 to 3, characterized in that the material for the box is made of mixed crystals of the general composition

$$Na_{1+x}Zr_{2-1/3x+y}Si_xP_{3-x}O_{12-2/3x+2y}$$

with the operating parameters $1.0 < x < 2.4$ and $0.1 < y < 0.2$ or

$$Na_{1+ax}Zr_{2+2/3x-ax}Si_xP_{3-x}O_{12-2/3x}$$

with a = constant numerical value between 0.8 and 0.9 and the operating parameter $1.8 < x < 2.3$.

## Revendications

1. Cellule électrochimique avec des électrodes solides et, placé entre ces électrodes, un électrolyte solide en céramique à conduction ionique à base d'une combinaison de solutions solides du type sodium zircon-phosphatosilicate qui présente à la température du local, une conductibilité minimale $\delta = 10^{-3}$ $\Omega^{-1}$ $cm^{-1}$, cellule caractérisée en ce que ces électrodes sont disposées dans les espaces intermédiaires d'un boîtier multi-couches (1) constitué par le matériau céramique à conduction ionique de l'électrolyte solide, tandis que sur les couches de ce boîtier des composants électroniques ou bien des circuits électroniques intégrés (11, 12) sont disposés et sont couplés avec les électrodes de la cellule électrochimique.

2. Cellule électrochimique selon la revendication 1, caractérisée en ce que l'une des couches du boîtier multicouches est l'électrolyte solide d'un affichage électrochrome.

3. Cellule électrochimique selon la revendication 2, caractérisée en ce que, dans le premier espace intermédiaire du boîtier multicouches, est disposée une électrode positive de batterie (2), dans le second espace intermédiaire une électrode Na négative (3), et dans le troisième espace intermédiaire une électrode sodiumtungstate (4), tandis que les couches externes du boîtier servent de substrat porteur pour une couche électrochrome WO3 et pour des éléments électroniques de commutation.

électrochrome $WO_3$ et pour des éléments électroniques de commutation.

4. Cellule électrochimique selon une des revendications 1 à 3, caractérisée en ce que le matériau pour le boîtier est constitué de solutions solides de compositions générales:

$$Na_{1+x}Zr_{2-1/3x+y}Si_xP_{3-x}O_{12-2/3x+2y}$$

avec les paramètres courants $1,0 < x < 2,4$ et $0,1 < y < 0,2$ ou bien:

$$Na_{1+ax}Zr_{2+2/3x-ax}Si_xP_{3-x}O_{12-2/3x}$$

avec a constant. Valeur numérique entre 0,8 et 0,9 et le paramètre courant $1,8 < x < 2,3$.